(19) Europäisches Patentamt
European Patent Office
Office européen des brevets

(11) **EP 4 034 923 B1**

(12) **FASCICULE DE BREVET EUROPEEN**

(45) Date de publication et mention de la délivrance du brevet:
**12.06.2024 Bulletin 2024/24**

(21) Numéro de dépôt: **20780676.1**

(22) Date de dépôt: **24.09.2020**

(51) Classification Internationale des Brevets (IPC):
**G02B 5/18** (2006.01)   **H01S 5/125** (2006.01)

(52) Classification Coopérative des Brevets (CPC):
**G02B 5/1861; H01S 5/021; H01S 5/125; H01S 5/141;** H01S 5/1032

(86) Numéro de dépôt international:
**PCT/EP2020/076799**

(87) Numéro de publication internationale:
**WO 2021/058690 (01.04.2021 Gazette 2021/13)**

(54) **SYSTÈME OPTIQUE ET PROCÉDÉ DE RÉALISATION**

OPTISCHES SYSTEM UND VERFAHREN ZU DESSEN HERSTELLUNG

OPTICAL SYSTEM AND METHOD FOR THE PRODUCTION THEREOF

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.09.2019 FR 1910714**

(43) Date de publication de la demande:
**03.08.2022 Bulletin 2022/31**

(73) Titulaire: **Commissariat à l'Energie Atomique et aux Energies Alternatives**
**75015 Paris (FR)**

(72) Inventeurs:
• **SCIANCALEPORE, Corrado**
**38054 Grenoble (FR)**
• **EL DIRANI, Houssein**
**38054 Grenoble (FR)**

(74) Mandataire: **Hautier IP**
**20, rue de la Liberté**
**06000 Nice (FR)**

(56) Documents cités:
**WO-A2-2005/089098**

• **D. BORDEL ET AL: "Heterogeneously Integrated III-V/Si Distributed Bragg Reflector Laser with Adiabatic Coupling", 39TH EUROPEAN CONFERENCE AND EXHIBITION ON OPTICAL COMMUNICATION (ECOC 2013), 1 janvier 2013 (2013-01-01), pages 687-689, XP055197576, DOI: 10.1049/cp.2013.1502 ISBN: 978-1-84-919759-5**
• **HAN YUN ET AL: "Broadband 2?x?2 adiabatic 3??dB coupler using silicon-on-insulator sub-wavelength grating waveguides", OPTICS LETTERS, vol. 41, no. 13, 1 juillet 2016 (2016-07-01), page 3041, XP055696463, US ISSN: 0146-9592, DOI: 10.1364/OL.41.003041**

EP 4 034 923 B1

## Description

DOMAINE TECHNIQUE

La présente invention concerne le domaine de l'optoélectronique. Elle trouve pour application particulièrement avantageuse la réalisation de sources laser à semiconducteurs, par exemple des lasers de télédétection LiDAR (acronyme de l'expression en langue anglaise « laser détection and ranging » soit en français « détection et estimation de la distance par laser ») ou pour des lasers datacom moyenne distance de type 400G Ethernet.

ÉTAT DE LA TECHNIQUE

Un miroir de Bragg permet de réfléchir un rayonnement lumineux en incidence normale audit miroir, en limitant les pertes optiques. Il peut ainsi présenter une réflectivité R supérieure à 99% pour un rayonnement lumineux de longueur d'onde λ donnée.

Les miroirs de Bragg sont donc particulièrement avantageux pour la fabrication de cavités optiques pour des applications laser, et notamment pour des sources laser à semiconducteurs.

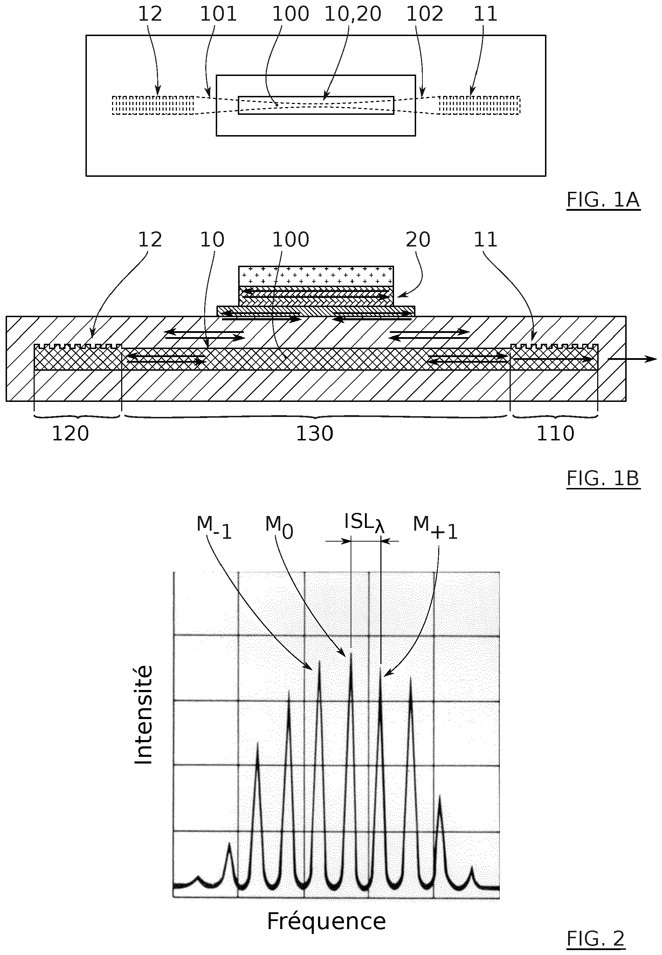

Une architecture connue de source laser à semiconducteurs est présentée aux figures 1A, 1B. Une telle architecture comprend typiquement un guide en ruban 100 s'étendant longitudinalement entre deux miroirs de Bragg 11, 12, transverses, et une cavité optique de type Fabry-Pérot comprenant un milieu amplificateur 20. Le milieu amplificateur 20 est ici une vignette en matériau III-V, par exemple en phosphure d'indium InP, reportée sur le ruban 100 en silicium. En pratique, les miroirs de Bragg sont réalisés par corrugation du guide en ruban 100. Ils présentent dès lors chacun un facteur de corrugation $\kappa$ et une longueur $L_g$ qui déterminent leurs propriétés de réflectivité. Le facteur de corrugation $\kappa$ peut s'exprimer selon :

$$\kappa = \frac{\pi . n_{eff,g}}{\lambda} \frac{\int\int_{\Omega} n_{inf}^2 n_{sup}^2 E^2 dx dy}{\int\int E^2 dx dy}$$

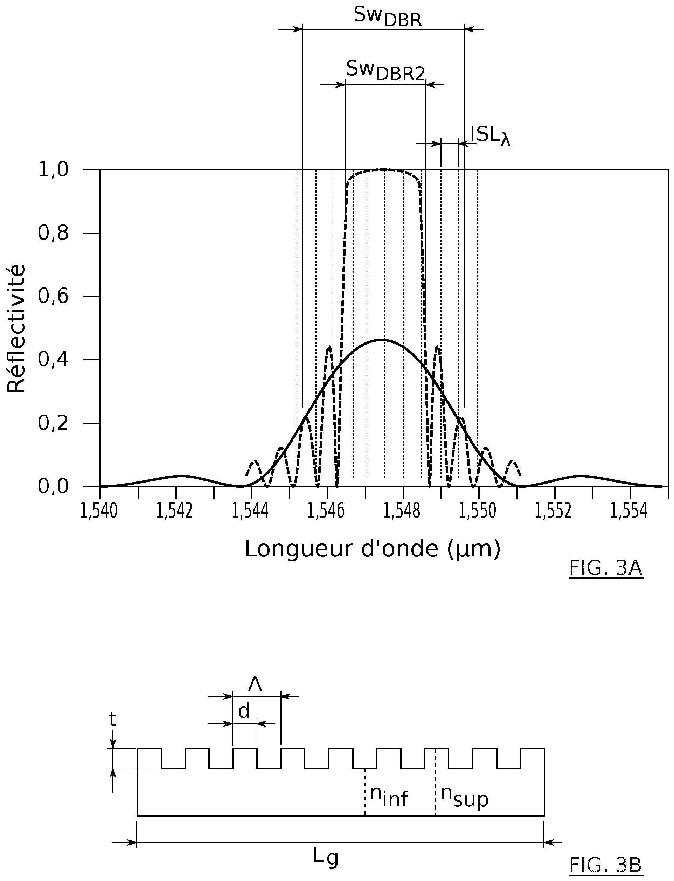

Où $\Omega$ est la section du mode optique se propageant dans le ruban, $n_{inf}$ et $n_{sup}$ sont respectivement les indices de réfraction effectifs du mode optique en correspondance avec respectivement les marches basses et les marches hautes du ruban comme illustré à la figure 3B, $n_{eff,g} = (n_{inf} - n_{sup})d\Lambda + n_{sup}$ est un indice effectif global du réseau formé par les corrugations (moyenne pondérée des indices liés aux marches basses et marches hautes) et E est le champ électrique du rayonnement lumineux en dehors de la région perturbée par les corrugations.

Un principe de fonctionnement de cette source laser est le suivant : le milieu amplificateur est pompé électriquement de façon à émettre un rayonnement lumineux présentant un spectre d'émission centré autour d'une longueur d'onde λ. Ce rayonnement lumineux se propage de façon guidée au sein de la cavité optique en étant réfléchi plusieurs fois par les miroirs de Bragg, selon un mode de propagation résonant appelé mode de cavité ou mode longitudinal. Après chaque réflexion, le rayonnement lumineux est réinjecté dans le milieu amplificateur de façon à stimuler l'émission. L'un des miroirs de Bragg, dit de confinement, présente une réflectivité R ≥ 99% et permet de limiter les pertes optiques de la cavité. L'autre miroir de Bragg, dit de sortie ou d'extraction, est partiellement réfléchissant (R ≤ 50%) et permet de transmettre un faisceau laser cohérent.

Ce faisceau laser présente généralement un spectre d'émission comprenant un ensemble discret de raies très fines autour de la longueur d'onde λ, à des longueurs d'onde définies par la cavité optique et le milieu amplificateur. Ce spectre d'émission du laser est illustré à la figure 2. Les différentes raies de ce spectre d'émission correspondent aux modes longitudinaux du faisceau laser. La largeur des raies dépend notamment des imperfections de la cavité optique et du bruit quantique généré au sein du milieu amplificateur.

L'espacement en longueur d'onde entre les modes longitudinaux correspond à l'intervalle spectral libre $ISL_\lambda$ (ou FSR en anglais, pour *free spectral range*) de la cavité optique, et dépend notamment de la longueur L de la cavité optique :

$$ISL_\lambda = \frac{\lambda^2}{2n_{eff}L}$$

Avec $n_{eff}$ l'indice effectif moyen de la cavité optique. Ainsi, en augmentant la longueur de cavité, l'$ISL_\lambda$ diminue et la bande spectrale du faisceau laser contient potentiellement plus de modes longitudinaux.

Le faisceau laser peut être caractérisé par sa pureté spectrale, qui reflète le nombre de modes longitudinaux de son spectre d'émission. La pureté spectrale du faisceau laser augmente lorsque le nombre de modes longitudinaux dans le spectre d'émission diminue. La pureté spectrale peut être exprimée comme le rapport des intensités des deux raies les plus intenses. En télécommunication, un faisceau laser est considéré comme monomode de longueur d'onde λ si ce rapport d'intensités, également connu sous l'acronyme SMSR (pour *Side Mode Suppression Ratio* en anglais, soit en français « ratio de suppression de la bande latérale »), est supérieur à environ 30 dB.

Une solution permettant d'améliorer la pureté spectrale du faisceau laser consiste à réduire la longueur de cavité. Ce type de solution n'est pas adapté pour des sources laser nécessitant une puissance optique élevée puisqu'en réduisant la longueur de cavité, la puissance optique du faisceau laser diminue.

Une autre solution permettant d'améliorer la pureté spectrale du faisceau laser consiste à dimensionner le miroir de Bragg de sortie de façon à filtrer spectralement le faisceau laser.

Les miroirs de Bragg de la cavité optique présentent chacun un pic de réflectivité centré sur la longueur d'onde $\lambda$.

Ce pic de réflectivité présente une certaine largeur spectrale $\delta\omega_{DBR}$ définissant la bande d'arrêt spectral ou « stopband » du miroir de Bragg.

Cette largeur de stopband $\delta\omega_{DBR}$ (en nm) dépend notamment du facteur de corrugation $\kappa$ du réseau de Bragg, également dénommé force du réseau, et de la longueur du réseau de Bragg $L_g$ :

$$\delta\omega_{DBR} = \frac{\pi}{v_g \sqrt{|\kappa|^2 + \left(\frac{\pi}{L_g}\right)^2}}$$

Où $v_g$ est la vitesse de groupe du rayonnement lumineux.

Une largeur de stopband $\delta\omega_{DBR}$ du miroir de sortie suffisamment faible permet de filtrer le spectre d'émission du faisceau laser et de réduire la largeur de ce spectre d'émission. La pureté spectrale du faisceau laser est ainsi d'autant meilleure que la stopband du miroir de sortie est étroite.

La figure 3A illustre la réflectivité R et la stopband du miroir de confinement ($L_g$ = 500 $\mu$m, R ≈ 100%, $\delta\omega_{DBR2}$ ≈ 2 nm) et du miroir de sortie ($L_g$ = 100 $\mu$m, R ≈ 46%, $\delta\omega_{DBR}$ ≈ 4 nm) d'une cavité optique d'$ISL_\lambda$ = 0,32 nm, pour un rayonnement lumineux de longueur d'onde $\lambda$ = 1547 nm. Les lignes verticales illustrent les différents modes longitudinaux du faisceau, séparés par l'$ISL_\lambda$.

Dans cet exemple, la cavité optique présente une longueur $L$ de l'ordre de 1 mm, et les miroirs de confinement et de sortie présentent des corrugations de hauteur $t$ = 10 nm. La figure 3B illustre en coupe un miroir de Bragg de longueur $L_g$ présentant de telles corrugations de hauteur $t$, de longueur d sur une période $\Lambda$.

Ce type de solution permet d'obtenir des sources laser infrarouge ($\lambda$ ≈ 1550 nm) monomode pour des applications de transmission de données (datacoms) ou de télécommunications (télécoms) nécessitant une puissance optique comprise entre 5 mW et 20 mW.

En revanche, pour des applications de type Li-DAR (télédétection par laser) ou des applications datacom moyenne distance de type 400G Ethernet, ce type de solution ne permet pas d'obtenir à la fois une puissance suffisante, typiquement supérieure à 100 mW, et un faisceau laser monomode.

Pour atteindre les puissances optiques requises pour ces applications, la longueur du milieu amplificateur et donc la longueur $L$ de la cavité optique doivent être augmentées. En particulier, la longueur de la cavité optique peut être au moins trois fois plus grande que celle de l'exemple précédent. Cette augmentation de longueur de cavité induit proportionnellement une diminution de l'intervalle spectral libre $ISL_\lambda$.

Les caractéristiques du miroir de sortie de l'exemple précédent ne permettent plus d'obtenir un faisceau monomode pour une telle cavité optique. En particulier, la largeur de stopband du miroir de sortie ($\delta\omega_{DBR}$ ≈ 4 nm) est trop grande en regard de l'intervalle spectral libre ($ISL_\lambda$ ≈ 0,11 nm) d'une telle cavité optique.

Il existe donc un besoin consistant à proposer un miroir de Bragg de sortie pour un laser à semiconducteur présentant une largeur de stopband réduite.

Un objet de la présente invention est de proposer un laser comprenant un tel miroir de Bragg de sortie.

En particulier, un objet de la présente invention est de proposer un laser à semiconducteur comprenant un miroir de Bragg de sortie améliorant la pureté spectrale du faisceau laser, notamment pour un laser à semiconducteur présentant une puissance optique supérieure ou égale à 100 mW.

Un autre objet de la présente invention est de proposer un procédé de réalisation d'un tel laser.

Un autre objet de la présente invention est de proposer un laser à semiconducteur monomode de puissance optique supérieure ou égale à 100 mW.

Les autres objets, caractéristiques et avantages de la présente invention apparaîtront à l'examen de la description suivante et des dessins d'accompagnement.

Il est entendu que d'autres avantages peuvent être incorporés. En particulier, certaines caractéristiques et certains avantages du miroir de Bragg peuvent s'appliquer *mutatis mutandis* au système optique et/ou au procédé, et réciproquement. Les documents "D. BORDEL ET AL: "Heterogeneously Integrated III-V/Si Distributed Bragg Reflector Laser with Adiabatic Coupling",39TH EUROPEAN CONFERENCE AND EXHIBITION ON OPTICAL COMMUNICATION (ECOC 2013), 1 janvier 2013 (2013-01-01), pages 687-689, XP055197576,DOI: 10.1049/cp.2013.1502ISBN: 978-1-84-919759-5", WO 2005/089098 A2 (UNIV CALIFORNIA [US]; CHANG-HASNAIN CONNIE J [US] ET AL.) 29 septembre 2005 (2005-09-29), et HAN YUN ET AL: "Broadband 2?x?2 adiabatic 3??dB coupler using silicon-on-insulator sub-wavelength grating waveguides",OPTICS LETTERS, vol. 41, no. 13, 1 juillet 2016 (2016-07-01), page 3041, XP055696463,US ISSN: 0146-9592, DOI: 10.1364/OL.41.003041 sont pertinents pour la présente invention.

RÉSUMÉ

Pour atteindre cet objectif, un premier aspect concerne un système optique comprenant un ruban à base d'un premier matériau, un premier miroir de Bragg formé à partir d'une première partie dudit ruban, un deuxième miroir de Bragg comprenant une deuxième partie du ruban, et une cavité optique située entre les premier et deuxième miroirs de Bragg comprenant une troisième partie du ruban et un milieu amplificateur à base d'un quatrième matériau, au niveau de ladite troisième partie du ruban.

Le premier miroir de Bragg comprend une première partie de ruban à base d'un premier matériau présentant un premier indice de réfraction n1. Le ruban s'étend principalement selon une première direction x et est destiné à guider une propagation d'un rayonnement lumineux de longueur d'onde λ selon ladite première direction x. Le premier miroir de Bragg comprend en outre des corrugations au niveau d'au moins une face de ladite première partie de ruban, lesdites corrugations s'étendant principalement selon une deuxième direction y normale à la première direction x et présentant une hauteur h3 selon une troisième direction z normale aux première et deuxième directions x, y.

Avantageusement, les corrugations sont séparées de ladite au moins une face de la première partie de ruban par une couche de séparation à base d'un deuxième matériau présentant une épaisseur e2 prise selon la troisième direction z et présentant un deuxième indice de réfraction n2.

Avantageusement, les corrugations sont à base d'un troisième matériau présentant un troisième indice de réfraction n3, tel que n2 < n3 et n2 < n1.

Ainsi, les corrugations sont en regard de la face du ruban et séparées de ladite face du ruban par la couche de séparation.

Le ruban guide la propagation du rayonnement lumineux selon x, longitudinalement. Le ou les modes optiques du rayonnement lumineux sont donc confinés dans le ruban. Le ruban présente ainsi des dimensions selon les directions transverses y, z inférieures et de préférence très inférieures à sa dimension selon x, et par exemple au moins 100 fois plus petite pour au moins une des directions y, z. Le confinement est typiquement obtenu en gainant le ruban par un matériau à faible indice de réfraction. Le confinement se fait ainsi par contraste d'indices, entre le ruban lui-même et la gaine entourant le ruban. Le confinement optique peut également être en partie dû à la géométrie du ruban, typiquement à la forme de sa section transverse.

Un tel ruban formant un guide optique est donc distinct d'un substrat, qui s'étend généralement à la fois en x et en y. Un substrat ne permet pas de guider une propagation d'un rayonnement lumineux selon une direction ou selon une seule direction. Un substrat est typiquement destiné à porter une pluralité de dispositifs. En particulier, un substrat peut porter le guide en ruban associé au miroir de Bragg selon l'invention.

Le ruban et le miroir comprenant une partie de ce ruban sont ainsi destinés au domaine de l'optique guidée. Le ruban est de préférence monomode, c'est-à-dire qu'il guide un seul mode de propagation du rayonnement lumineux, typiquement le mode fondamental. La partie de ruban intégrée au miroir présente typiquement les mêmes caractéristiques que le ruban lui-même. Cette partie de ruban permet en particulier de confiner le rayonnement lumineux. Des fractions du rayonnement lumineux confiné dans la partie de ruban du miroir sont ainsi réfléchies selon x, par chacune des corrugations du miroir. Les fractions réfléchies en phase reforment ainsi un rayonnement lumineux réfléchi selon x. Le miroir assure donc une fonction primaire de réflexion, mais comprend aussi une fonction de propagation de lumière.

Les corrugations perturbent la propagation du rayonnement lumineux. Le facteur de corrugation $\kappa$ détermine ainsi en partie la largeur de stopband $\delta\omega_{DBR}$. Plus le facteur de corrugation est important, plus la largeur de stopband du miroir augmente. A contrario, lorsque le facteur de corrugation diminue, la largeur de stopband du miroir diminue.

Une solution permettant de diminuer le facteur de corrugation consiste à diminuer la hauteur des corrugations. Dans le cadre du développement de la présente invention, il s'est avéré en pratique que les technologies de gravure requises pour obtenir de façon reproductible et maîtrisée des corrugations présentant une hauteur de l'ordre de quelques nanomètres sont très difficiles à mettre en oeuvre.

Au contraire, dans le présent cas, la diminution du facteur de corrugation est obtenue en s'affranchissant d'une diminution de hauteur des corrugations.

Ainsi, l'utilisation d'une couche de séparation permet d'éloigner physiquement les corrugations du ruban dans lequel se propage le rayonnement lumineux. L'intensité des perturbations décroît avec l'augmentation de distance, selon la troisième direction *z*, entre les corrugations et le ruban. Le facteur de corrugation $\kappa$ et la largeur de stopband $\delta\omega_{DBR}$ du miroir de Bragg sont ainsi diminués par cet effet d'éloignement ou de séparation physique.

L'utilisation d'un deuxième matériau pour cette couche de séparation, typiquement un matériau diélectrique, présentant un faible indice de réfraction relativement à ceux du ruban et des corrugations permet en outre de séparer optiquement les corrugations du ruban dans lequel se propage le rayonnement lumineux.

La couche de séparation d'indice de réfraction n2 a donc un effet synergique en éloignant physiquement les corrugations du ruban, et en modulant optiquement le rayonnement lumineux avec un faible indice. Cela permet de diminuer d'autant plus la largeur de stopband du miroir de Bragg.

Les corrugations sont ainsi « flottantes » vis-à-vis du ruban. D'un point de vue électromagnétique, les corrugations forment des ilots perturbant le champ électromagnétique du rayonnement lumineux se propageant dans le ruban. Les perturbations électromagnétiques du rayonnement lumineux sont atténuées par une barrière diélectrique. Elles décroissent en outre naturellement avec l'augmentation de distance entre les ilots et le ruban. Ces corrugations flottantes présentent un facteur de corrugation diminué.

Le système optique peut avantageusement former un laser présentant une grande pureté spectrale. Un tel laser équipé d'un miroir de sortie dont la largeur de stopband est diminuée peut en outre présenter une longueur de cavité augmentée tout en restant avantageusement monomode. La puissance optique du laser peut ainsi être augmentée, par exemple à une valeur supérieure ou égale à 100 mW, en conservant un SMSR supérieur à 30 dB.

Un deuxième aspect concerne un procédé de fabrication d'un laser comprenant les étapes suivantes :

- Fournir un ruban à base d'un premier matériau présentant un premier indice de réfraction n1, ledit ruban s'étendant principalement selon une première direction x et présentant une face s'étendant dans un plan d'extension principal xy formé par la première direction x et une deuxième direction y normale à la première direction x,
- Déposer au moins sur une première partie de ladite face du ruban une couche de séparation à base d'un deuxième matériau présentant un deuxième indice de réfraction n2 tel que n2 < n1, ladite couche de séparation présentant une épaisseur e2 prise selon une troisième direction z normale aux première et deuxième directions x, y,

- Déposer, sur la couche de séparation, une couche de perturbation à base d'un troisième matériau présentant un troisième indice de réfraction n3, tel que n2 < n3, ladite couche de perturbation présentant une épaisseur e3 prise selon la troisième direction z,
- Graver la couche de perturbation de manière à former des corrugations s'étendant principalement selon la deuxième direction y, et présentant une hauteur h3 ≤ e3 selon la troisième direction z, lesdites corrugations formant avec la couche de séparation et la première partie du ruban un premier miroir de Bragg,
- Former un deuxième miroir de Bragg au niveau d'une deuxième partie du ruban,
- Reporter, au niveau d'une troisième partie du ruban située entre les première et deuxième parties, un milieu amplificateur à base d'un quatrième matériau.

La hauteur h3 des corrugations est de préférence supérieure à 10 nm, et de préférence supérieure à 20 nm. La gravure d'une telle hauteur h3 est plus facilement réalisable qu'une gravure de moins de quelques nanomètres, par exemple de moins de 5 nm. L'étape de gravure des corrugations selon le procédé de l'invention est donc simplifiée par rapport à une solution visant à diminuer la hauteur des corrugations. Avantageusement, la couche de séparation peut servir de couche d'arrêt à la gravure de la couche de perturbation et h3 = e3. Ainsi, la hauteur h3 des corrugations est parfaitement reproductible et bien maîtrisée. La face du ruban est en outre protégée d'une éventuelle surgravure lors de la gravure des corrugations. Cela permet de réaliser un miroir de Bragg présentant un facteur de qualité élevé.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

- Les figures 1A et 1B illustrent respectivement en vue de dessus et en coupe une architecture connue de source laser à semiconducteurs.
- La figure 2 représente un spectre d'émission typique d'un laser.
- La figure 3A illustre la réflectivité et la stopband des miroirs de confinement et de sortie d'un laser selon l'art antérieur.
- La figure 3B illustre en coupe un miroir de Bragg présentant des corrugations selon l'art antérieur.
- La figure 4A montre une vue en coupe dans un plan yz d'un miroir de Bragg selon un mode de réalisation de la présente invention.
- La figure 4B montre une vue en coupe dans un plan xz d'un miroir de Bragg selon un mode de réalisation de la présente invention.
- La figure 5A montre une vue de dessus d'un miroir de Bragg selon un mode de réalisation de la présente invention.
- La figure 5B montre une vue de dessus d'un miroir de Bragg selon un autre mode de réalisation de la présente invention.
- La figure 6A montre la réflectivité et la stopband d'un miroir de Bragg selon l'art antérieur.
- La figure 6B montre la réflectivité et la stopband d'un miroir de Bragg selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches et corrugations du miroir de Bragg ne sont pas représentatives de la réalité.

## DESCRIPTION DETAILLEE

Avant d'entamer une revue détaillée de modes de réalisation de l'invention, il est rappelé que le premier miroir de Bragg comprend notamment les caractéristiques optionnelles ci-après pouvant être utilisées en association ou alternativement :
Selon un exemple, les corrugations sont séparées les unes des autres de sorte que la couche de séparation est exposée entre lesdites corrugations.
Selon un exemple, les corrugations sont encapsulées dans une couche d'encapsulation à base du deuxième matériau.

Selon un exemple, la hauteur h3 des corrugations est supérieure ou égale à 5 nm et/ou inférieure ou égale à 30 nm.

Selon un exemple, l'épaisseur e2 de la couche de séparation est supérieure ou égale à 10 nm et/ou inférieure ou égale à 50 nm.

Selon un exemple, les corrugations présentent un motif adiabatique en projection dans un plan d'extension principal xy formé par les première et deuxième directions x, y.

Selon un exemple, la hauteur h3 et l'épaisseur e2 sont configurées de sorte que le miroir présente une largeur de bande spectrale $\delta\omega_{DBR}$ inférieure ou égale à 0,5 nm.

Selon un exemple, le premier indice de réfraction n1 est supérieur ou égal à 3, le deuxième indice de réfraction n2 est inférieur ou égal à 2, et le troisième indice de réfraction n3 est supérieur ou égal à 1,5.

Selon un exemple, les troisième et deuxième indices de réfraction sont tels que n3 - n2 ≤ 0,5.

Selon un exemple, le premier matériau est du silicium, le deuxième matériau est un oxyde de silicium, le troisième matériau est pris parmi un nitrure de silicium, un nitrure d'aluminium, un oxyde d'aluminium, un oxyde de tantale.

Selon un exemple, le ruban forme un guide monomode.

Selon un exemple, le miroir présente une entrée et une sortie selon un plan transverse à la première direction x de propagation du rayonnement lumineux.

Selon un exemple, les corrugations sont comprises dans une couche, dite couche de perturbation, parallèle à la première direction x de propagation du rayonnement lumineux.

L'invention selon son premier aspect comprend notamment les caractéristiques optionnelles ci-après pouvant être utilisées en association ou alternativement :
Selon un exemple, la cavité optique présente une longueur Le selon la première direction x supérieure ou égale à 500 μm, de préférence supérieure ou égale à 1 mm, et de préférence supérieure ou égale à 3 mm.

Selon un exemple, le deuxième miroir de Bragg présente une réflectivité supérieure ou égale à 99% et une largeur de bande spectrale $\delta\omega_{DBR2}$ supérieure ou égale à 2 nm.

Selon un exemple, le deuxième miroir de Bragg comprend des deuxièmes corrugations à base du premier matériau directement au contact d'au moins une face de la deuxième partie du ruban, lesdites deuxièmes corrugations présentant une hauteur h2 supérieure ou égale à 5 nm.

Selon un exemple, le système optique forme un laser de télédétection configuré pour être mis en oeuvre dans un système de détection et d'estimation d'une distance par laser, appelé LiDAR (acronyme anglais de « laser détection and ranging »).

L'invention selon son deuxième aspect comprend notamment les caractéristiques optionnelles ci-après pouvant être utilisées en association ou alternativement :
Selon un exemple, le procédé comprend en outre une encapsulation des corrugations par une couche d'encapsulation à base du deuxième matériau.

Selon un exemple, l'arrêt de la gravure est effectué au niveau d'une interface entre la couche de séparation et la couche de perturbation, de sorte que la hauteur h3 des corrugations soit égale à l'épaisseur e3 de la couche de perturbation.

Selon un exemple, la gravure présente une sélectivité $S_{p:s}$ entre les couches de perturbation et de séparation supérieure ou égale à 2 :1, préférentiellement supérieure ou égale à 50:1.

Selon un exemple, la hauteur h3 des corrugations est supérieure ou égale à 5 nm et/ou inférieure ou égale à 30 nm et l'épaisseur e2 de la couche de séparation est supérieure ou égale à 20 nm et/ou inférieure ou égale à 50 nm.

Sauf incompatibilité, il est entendu que le miroir, le procédé de fabrication, et le système optique peuvent comprendre, *mutatis mutandis*, l'ensemble des caractéristiques optionnelles ci-dessus.

Dans le cadre de la présente invention, les locutions « miroir de Bragg », « réseau de Bragg » ou « réflecteur de Bragg distribué » ou encore « DBR (Distributed Bragg Reflector) » sont employées en synonymes. Le miroir de Bragg est ici configuré pour être utilisé comme réflecteur dans un guide d'onde. Il comprend une alternance de matériaux d'indices de réfraction différents. Cette alternance induit une variation périodique de l'indice de réfraction effectif dans le guide d'onde. Une telle alternance est reproduite au moins deux fois dans le cadre d'un miroir de Bragg selon la présente invention.

Le guide d'onde coopérant avec le miroir de Bragg est de préférence un guide d'onde de type ruban notamment utilisé pour des applications de laser à ruban. Un laser à ruban peut être de type DBR (pour *Distributed Bragg Reflector,* soit réflecteur de Bragg distribué en français) ou de type DFB (pour *Distributed FeedBack* ou laser à rétroaction répartie en français). Un laser DBR comprend typiquement deux miroirs de Bragg. Un laser DFB comprend typiquement un seul miroir de Bragg.

Le ruban s'étend de façon continue selon une direction principale x. Il guide la propagation du rayonnement lumineux selon x. Comme illustré à la figure 1A, la section du ruban dans un plan yz n'est pas nécessairement constante le long du ruban 100. En particulier, un ou des fuseaux 101, 102 (ou *taper* en anglais) peuvent localement moduler la propagation du rayonnement lumineux. Cela permet par exemple un passage adiabatique entre la propagation du rayonnement lumineux dans la partie 10 (ruban) de la cavité et la propagation du rayonnement lumineux dans la partie 20 (milieu amplificateur) de la cavité. La section du ruban peut également présenter une forme variable. Selon l'exemple illustré à la figure 1A, elle peut être rectangulaire au niveau des miroirs de Bragg 11, 12, et peut présenter un profil en arrête au niveau de la cavité optique 10. Dans le cadre de la présente invention, le ruban peut désigner un guide en ruban, ou peut désigner une partie seulement d'un guide en arête, typiquement la partie centrale de plus grande épaisseur d'un guide en arête. Ainsi, un guide en arête comprend un ruban au sens de la présente invention.

Le ruban comprend typiquement plusieurs parties contribuant respectivement à la formation du ou des miroirs de Bragg et de la cavité optique d'un laser à ruban de type DBR ou DFB. Comme illustré à la figure 1B, une première partie 110 du ruban 100 correspond à un premier miroir de Bragg 11, une deuxième partie 120 du ruban 100 correspond à un deuxième miroir de Bragg 12, et une troisième partie 130 du ruban 100 correspond à la cavité optique. La partie du ruban comprise dans le miroir de Bragg coopère donc nécessairement avec le reste du ruban.

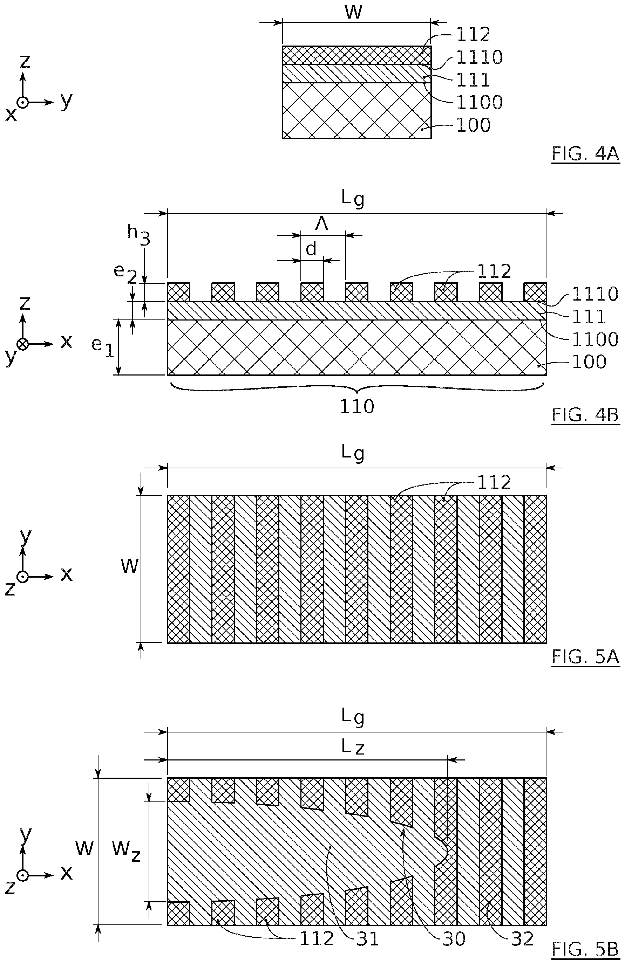

Le ou les miroirs de Bragg comprennent des corrugations au niveau d'au moins une face du ruban. Ces corrugations sont en saillie depuis la face du ruban. Elles s'étendent transversalement à la direction principale longitudinale x. Une « corrugation » correspond donc à un relief transverse proéminent. Les corrugations d'un miroir de Bragg selon l'art antérieur sont typiquement directement au contact de la face du ruban (figure 3B). Les corrugations d'un miroir de Bragg selon la présente invention sont typiquement séparées de la face du ruban par une couche de séparation (figure 4B).

Il est précisé que, dans le cadre de la présente invention, une troisième couche intercalée entre une première couche et une deuxième couche ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément, à moins qu'il n'en soit disposé autrement.

Les étapes de formation des couches, notamment celles de séparation et celle de perturbation s'entendent au sens large : elles peuvent être réalisées en plusieurs sous-étapes qui ne sont pas forcément strictement successives.

On entend par un substrat, un film, une couche, « à base » d'un matériau M, un substrat, un film, une couche comprenant ce matériau M uniquement ou ce matériau M et éventuellement d'autres matériaux, par exemple des éléments d'alliage, des impuretés ou des éléments dopants. Le cas échéant, le matériau M peut présenter différentes stoechiométries. Ainsi, une couche en un matériau à base de nitrure de silicium peut par exemple être une couche de SiN ou une couche de $Si_3N_4$ (généralement appelé nitrure de silicium stœchiométrique).

Dans la présente demande de brevet, les première, deuxième et troisième directions correspondent respectivement aux directions portées par les axes x, y, z d'un repère de préférence orthonormé. Ce repère est représenté sur les figures annexées.

Dans la suite, la longueur est prise selon la première direction x, la largeur est prise selon la deuxième direction y, et l'épaisseur est prise selon la troisième direction z.

Dans la suite, un indice de réfraction est défini pour un matériau, éventuellement pour un matériau moyen ou modèle, et pour une longueur d'onde d'un rayonnement lumineux dans ce matériau. L'indice de réfraction est égal au rapport de la célérité c (vitesse de la lumière dans le vide) sur la vitesse de propagation de la lumière dans le matériau considéré. La lumière est supposée se propager selon la direction longitudinale x.

n1 est un premier indice de réfraction pour une propagation d'un flux lumineux de longueur d'onde λ dans le premier matériau.

n2 est un deuxième indice de réfraction pour une propagation d'un flux lumineux de longueur d'onde λ dans le deuxième matériau.

n3 est un troisième indice de réfraction pour une propagation d'un flux lumineux de longueur d'onde λ dans le troisième matériau.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de $90 \pm 10°$ par rapport au plan.

Pour déterminer la géométrie d'un miroir de Bragg, on peut procéder à des analyses de Microscopie Electronique à Balayage (MEB) ou de Microscopie Electronique en Transmission (MET ou TEM pour l'acronyme anglais de « Transmission Electron Microscopy »). Ces techniques sont bien adaptées pour déterminer les dimensions de structures nanométriques. Elles peuvent être mises en oeuvre à partir de coupes métallurgiques ou de lames minces pratiquées au travers des dispositifs, selon des méthodes typiques d'analyse de construction ou d'ingénierie inverse.

Les compositions chimiques des différents matériaux peuvent être déterminées à partir d'analyses de type EDX ou X-EDS (acronyme de « energy dispersive x-ray spectroscopy » soit spectroscopie à rayons X à dispersion d'énergie en français). Cette technique est bien adaptée pour analyser la composition de structures de petites tailles telles que des corrugations de faibles épaisseurs. Elle peut être mise en oeuvre sur des coupes métallurgiques au sein d'un Microscope Electronique à Balayage (MEB) ou sur des lames minces au sein d'un Microscope Electronique en Transmission (MET).

Les mesures de réflectivité et de stopband d'un miroir de Bragg peuvent être effectuées par spectroscopie infrarouge, par exemple par spectroscopie infrarouge à transformée de Fourier (FTIR). La largeur de stopband d'un miroir de Bragg est mesurée à mi-hauteur. La réflectivité et la stopband d'un miroir de Bragg peuvent également être déterminées par le biais de calculs de différences finies dans le domaine temporel, dites méthodes FDTD (*Finite Difference Time Domain*).

L'invention va maintenant être décrite en détail au travers de quelques modes de réalisation non limitatifs.

En référence aux figures 4A, 4B et 5A, un premier mode de réalisation d'un miroir de Bragg 11 comprend une première partie 110 de ruban 100 en silicium, une couche de séparation 111 en oxyde de silicium directement formée sur une face 1100 de la partie 110, et des corrugations 112 en nitrure de silicium directement formées sur une face 1110 de la couche de séparation 111.

La partie 110 peut être alternativement en un alliage de silicium, par exemple du silicium-germanium, ou en germanium. Elle présente un indice de réfraction n1 typiquement supérieur à 3. Elle présente une épaisseur e1 par exemple de l'ordre de 500 nm. Elle peut être formée par lithographie/gravure à partir d'un substrat de type silicium sur isolant SOI ou germanium sur isolant GeOI (respectivement pour *Silicon On Insulator* et *Germanium On Insulator*). Cette partie 110 peut présenter une longueur Lg de l'ordre de 50 μm à 1000 μm, et une largeur W de l'ordre de 5 μm à 20 μm. La partie 110 est ainsi typiquement bordée par une couche d'oxyde sous-jacente et par des couches d'oxyde latérales (non illustré).

La face 1100 de cette partie 110 n'est avantageusement pas structurée, contrairement aux solutions connues recourant à une structuration périodique sous forme de corrugations de la face du ruban. Les problématiques de gravure complexes de corrugations de très faible épaisseur (< 5 nm) sont ainsi avantageusement supprimées. La partie 110 est bordée par la couche de séparation 111 au niveau de sa face 1100.

La couche de séparation 111 présente une épaisseur e2 de préférence comprise entre 10 nm et 50 nm, par exemple comprise entre 20 nm et 40 nm. Elle présente un indice de réfraction n2 inférieur à 2. La formation d'une telle couche de séparation 111 en oxyde de silicium est parfaitement connue et facilement réalisable. Elle peut être formée par oxydation thermique du silicium exposé au niveau de la face 1100 de la partie 110 du ruban 100. Alternativement, elle peut être déposée par des techniques de dépôt, par exemple de type dépôt chimique en phase vapeur CVD (Chemical Vapor Déposition). La couche de séparation 111 couvre toute la face 1100.

Les corrugations 112 sont de préférence directement au contact de la couche de séparation 111. Elles présentent une hauteur h3 supérieure à 5 nm, de préférence supérieure à 10 nm, par exemple de l'ordre de 20 nm à 25 nm, voire jusqu'à environ 50 nm. Une telle gamme de hauteur h3 de corrugations permet un réglage plus fin du facteur de corrugation du miroir.

Les corrugations 112 présentent une longueur d et une période Λ calculées en fonction de la longueur d'onde λ du rayonnement lumineux. Typiquement, la longueur d est égale à :

$$d = \frac{\lambda}{4.\,neff}$$

La période Λ est égale à :

$$\Lambda = \frac{\lambda}{2.\,neff}$$

Pour un rayonnement de longueur d'onde λ environ égale à 1.5 μm, la longueur d est typiquement de l'ordre de 150 nm et la période Λ est typiquement de l'ordre de 250 nm environ. La largeur des corrugations est de préférence supérieure ou égale à W. Une largeur de corrugations légèrement supérieure à la largeur W du ruban 100 permet de pallier à d'éventuels défauts d'alignement selon z des corrugations vis-à-vis du ruban. La probabilité que les corrugations 112 couvrent toute la largeur W du ruban est ainsi améliorée. Le dimensionnement des corrugations dans le plan xy est connu en soi.

Les corrugations présentent un indice de réfraction n3 supérieur à 1,5 et supérieur à n2. Elles sont de préférence en nitrure de silicium. Elles peuvent être alternativement et non limitativement en nitrure d'aluminium, ou en oxyde d'aluminium, ou en oxyde de tantale.

La formation des corrugations se fait de préférence en deux étapes. Une première étape consiste à déposer, par exemple par CVD, une couche dite de perturbation sur la couche de séparation 111. Cette couche de perturbation présente une épaisseur e3. Une deuxième étape consiste à structurer la couche de perturbation par lithographie/gravure de façon à former les corrugations 112. La gravure se fait de préférence par voie sèche. La profondeur de gravure correspond à la hauteur h3 des corrugations. Les corrugations 112 sont de préférence distinctes et séparées les unes des autres, tel qu'illustré à la figure 4B. Dans ce cas, h3 = e3 et la face 1110 de la couche de séparation 111 est exposée entre les corrugations à l'issue de la gravure. La couche de séparation 111 sert dès lors avantageusement de couche d'arrêt à la gravure. La gravure présente de préférence une sélectivité S$_{p:s}$ entre les couches de perturbation et de séparation supérieure ou égale à 2:1, dans le cas d'une gravure sèche, voire à 50:1, notamment dans le cas d'une gravure humide.

Alternativement, les corrugations 112 présentent une hauteur h3 inférieure à l'épaisseur e3 de la couche de perturbation. Elles sont reliées entre elles par une partie inférieure de la couche de perturbation au contact de la couche de séparation 111. La gravure est dans ce cas stoppée avant d'atteindre la face 1110 de la couche de séparation 111.

Après gravure, les corrugations 112 sont de préférence encapsulées par un dépôt d'oxyde de silicium, par exemple par CVD. La couche d'encapsulation recouvre de préférence l'ensemble de la face du miroir comprenant les corrugations et opposées au ruban ; elle remplit aussi avantageusement les espaces entre les corrugations, recouvrant ainsi les portions exposées de la couche de séparation (qui s'entendent des portions non recouvertes par des corrugations).

Selon ce premier mode de réalisation, les corrugations s'apparentent ainsi à des barreaux de nitrure de silicium noyés dans une matrice d'oxyde de silicium, tel qu'illustré à la figure 5A. Les corrugations présentent de préférence une largeur constante. Le miroir de Bragg ainsi formé comprend quelques dizaines de corrugations sur sa longueur Lg. Le nombre de corrugations est par exemple compris entre 10 et 100.

Selon un deuxième mode de réalisation illustré à la figure 5B, les corrugations 112 sont arrangées selon un motif dit adiabatique. Seul cet arrangement des corrugations diffère du premier mode de réalisation, toutes choses étant égales par ailleurs. Un tel motif adiabatique présente dans le plan xy un profil 30 effilé, par exemple en pointe ou en parabole, délimitant une première zone 31 sans corrugations et une deuxième zone 32 avec corrugations 112. La face 1110 de la couche de séparation 111 est dans ce cas exposée sur toute la zone 31 dépourvue de corrugations 112. La zone 31 est de préférence centrée sur la zone 32 selon la direction y.

Un tel motif adiabatique permet de façon connue de moduler progressivement la propagation du rayonnement lumineux lors de la réflexion sur le miroir de Bragg. Cela permet de limiter les pertes optiques par diffraction au niveau du miroir de Bragg. Les pertes parasites de la cavité optique sont ainsi limitées. La zone 31 présente ainsi une largeur progressivement décroissante depuis un premier côté du miroir destiné à jouxter la cavité optique ou le guide d'onde dans lequel se propage le rayonnement lumineux, vers le deuxième côté du miroir opposé au premier côté selon la direction x. La zone 32 comprend des parties de corrugations bordant la zone 31, et des corrugations complètes - c'est-à-dire s'étendant selon toute la largeur W - au niveau du deuxième côté du miroir. Le nombre de corrugations complètes de la zone 32 peut être compris entre 5 et 20.

La largeur maximale Wz de la zone 31 est de préférence inférieure à la largeur W de la zone 32. Le rapport des largeurs Wz/W peut être compris entre 0,5 et 0,9. La longueur Lz de la zone 31 est inférieure à la longueur Lg de la zone 32. Le rapport des longueurs Lz/Lg peut être compris entre 0,5 et 0,9. La surface de la zone 31 peut être inférieure à celle de la zone 32. Le rapport des surfaces des zones 31, 32 peut être compris entre 0,5 et 0,9.

Les miroirs de Bragg ainsi formés selon ces premier et deuxième modes de réalisation présentent une largeur de stopband réduite. Le miroir de Bragg formé selon le deuxième mode de réalisation présente en outre une efficacité améliorée.

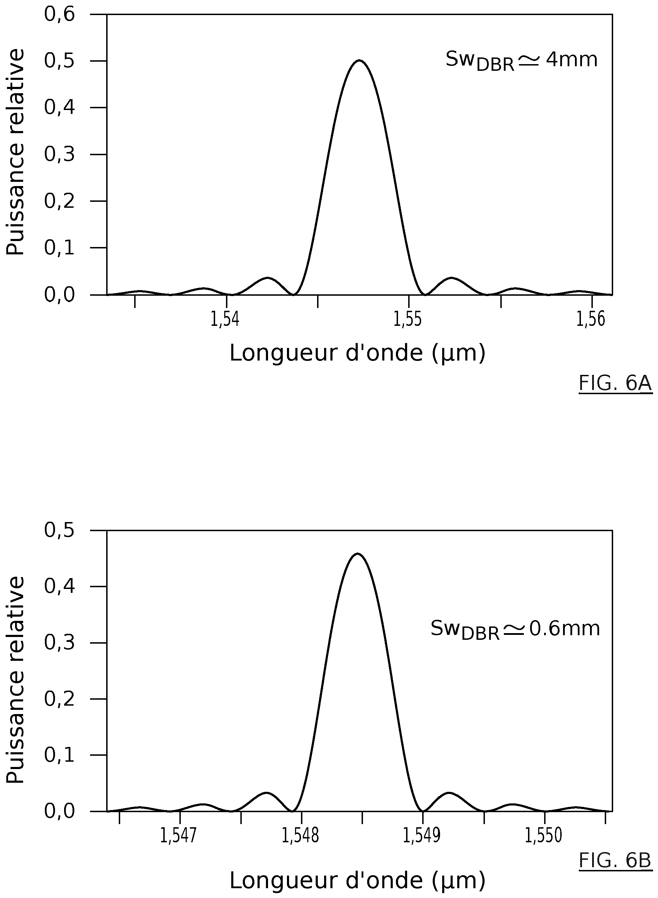

Les figures 6A et 6B comparent les largeurs de stopband $\delta\omega_{DBR}$ d'un miroir selon l'art antérieur (figure 6A) et d'un miroir selon la présente invention (figure 6B). Pour des réflectivités similaires de l'ordre de 50%, la largeur de stopband du miroir selon l'invention ($\delta\omega_{DBR} \approx 0,6$ nm, figure 6B) est très significativement réduite en comparaison de la largeur de stopband du miroir selon l'art antérieur ($\delta\omega_{DBR} \approx 4$ nm, figure 6A). Une largeur de stopband $\delta\omega_{DBR} \approx 0,6$ nm présentée dans cet exemple n'est pas une valeur limite de largeur de stopband d'un miroir selon l'invention. Cette largeur de stopband peut encore être diminuée, par exemple en augmentant l'épaisseur e2 de la couche de séparation et/ou en diminuant la hauteur h3 des corrugations.

Un tel miroir de Bragg peut avantageusement être mis en oeuvre en tant que miroir de sortie d'un laser à ruban de type DBR. En particulier, l'architecture dite III-V sur Si illustrée aux figures 1A et 1B peut être utilisée en remplaçant le miroir 11 selon l'art antérieur par le miroir de Bragg décrit dans la présente invention. L'utilisation de ce miroir à largeur de stopband réduite permet d'allonger la cavité optique 10 tout en conservant un faisceau laser monomode. En allongeant la cavité optique d'un facteur X par rapport à une longueur L d'une cavité d'un laser pris comme référence, l'intervalle spectral libre $ISL_\lambda$ est réduit du même facteur X. Pour conserver le rapport SMSR du faisceau laser de référence, il est alors nécessaire de réduire la largeur de stopband de ce même facteur X.

Il apparaît donc clairement que le miroir de Bragg selon l'invention convient à la réalisation de laser à ruban III-V sur Si de type DBR présentant une cavité optique X fois plus grande que celle du laser de référence. En augmentant proportionnellement la longueur, et donc le volume, du milieu amplificateur, la puissance d'un tel laser est également environ X fois supérieure à celle du laser de référence. Le miroir de Bragg selon l'invention permet donc de réaliser un laser III-V sur Si environ X fois plus puissant qu'un laser de référence comprenant un miroir de Bragg selon l'art antérieur. Ce facteur X est d'au moins 6 dans le cadre de la présente invention.

Un laser III-V sur Si comprenant un miroir de sortie tel que décrit dans la présente invention peut ainsi présenter une longueur de cavité L de l'ordre de 3 mm, une longueur de milieu amplificateur de l'ordre de 2 mm et un $ISL_\lambda$ de l'ordre de 0,11 nm. Un tel laser présente avantageusement une puissance optique supérieure ou égale à 100 mW, en conservant un SMSR supérieur à 30 dB pour une longueur d'onde d'émission de l'ordre de 1,5 μm. Le miroir 12 de confinement de ce laser comprend de préférence des corrugations formées directement sur la partie 120 du ruban 100. Il présente ainsi une largeur de stopband très supérieure à celle du miroir 11 de sortie. Cela permet de bénéficier d'une réflectivité quasi-totale (R ≥ 99%) sur une large bande (par exemple $\delta\omega_{DBR2} \geq 10$ nm) pour le miroir 12, et d'une semi-réflectivité (R ≤ 50%) sur une bande très fine (par exemple $\delta\omega_{DBR} \leq 0,6$ nm) pour le miroir 11. Un tel laser est avantageusement utilisable pour des applications LiDAR et télécom 400G longue distance.

L'invention n'est pas limitée aux modes de réalisations précédemment décrits et s'étend à tous les modes de réalisation couverts par les revendications.

## Revendications

1. Système optique comprenant :

   - un ruban (100) à base d'un premier matériau présentant un premier indice de réfraction n1, ledit ruban (100) s'étendant principalement selon une première direction (x) et étant destiné à guider une propagation d'un rayonnement lumineux de longueur d'onde λ selon ladite première direction (x),
   - un premier miroir de Bragg (11) formé à partir d'une première partie dudit ruban (100), ledit premier miroir de Bragg (11) comprenant en outre des corrugations (112) au niveau d'au moins une face (1100) de ladite première partie (110) de ruban (100), lesdites corrugations (112) s'étendant principalement selon une deuxième direction (y) normale à la première direction (x) et présentant une hauteur h3 selon une troisième direction (z) normale aux première et deuxième directions (x, y), les corrugations (112) dudit premier miroir de Bragg (11) étant séparées de ladite au moins une face (1100) de la première partie (110) de ruban (100) par une couche de séparation (111) à base d'un deuxième matériau présentant une épaisseur e2 prise selon la troisième direction (z) et présentant un deuxième indice de réfraction n2, les corrugations (112) étant à base d'un troisième matériau présentant un troisième indice de réfraction n3, tel que n2 < n3 et n2 < n1,
   - un deuxième miroir de Bragg (12) comprenant une deuxième partie du ruban (100), et
   - une cavité optique située entre les premier et deuxième miroirs de Bragg (11, 12) comprenant une troisième partie du ruban (100) et
   - un milieu amplificateur à base d'un quatrième matériau, au niveau de ladite troisième partie du ruban (100).

2. Système optique selon la revendication précédente dans lequel les corrugations (112) sont encapsulées dans une couche d'encapsulation à base du deuxième matériau.

3. Système optique selon l'une quelconque des revendications précédentes dans lequel la hauteur h3 des corrugations est supérieure ou égale à 5 nm et/ou inférieure ou égale à 30 nm.

4. Système optique selon l'une quelconque des revendications précédentes dans lequel l'épaisseur e2 de la couche de séparation (111) est supérieure ou égale à 10 nm et/ou inférieure ou égale à 50 nm.

5. Système optique selon l'une quelconque des revendications précédentes dans lequel les corrugations présentent un motif (30) adiabatique en projection dans un plan d'extension principal (xy) formé par les première et deuxième directions (x, y).

6. Système optique selon l'une quelconque des revendications précédentes dans lequel la hauteur h3 et l'épaisseur e2 sont configurées de sorte que le premier miroir (11) présente une largeur de bande spectrale $\delta\omega_{DBR}$ inférieure ou égale à 0,5 nm.

7. Système optique selon l'une quelconque des revendications précédentes dans lequel le premier indice de réfraction n1 est supérieur ou égal à 3, le deuxième indice de réfraction n2 est inférieur ou égal à 2, et le troisième indice de réfraction n3 est supérieur ou égal à 1,5.

8. Système optique selon l'une quelconque des revendications précédentes dans lequel la cavité optique présente une longueur Le selon la première direction (x) supérieure ou égale à 500 $\mu$m, de préférence supérieure ou égale à 1 mm, et de préférence supérieure ou égale à 3 mm.

9. Système optique selon l'une quelconque des revendications précédentes dans lequel le deuxième miroir de Bragg (12) présente une réflectivité supérieure ou égale à 99% et une largeur de bande spectrale $\delta\omega_{DBR2}$ supérieure ou égale à 2 nm.

10. Système optique selon l'une quelconque des revendications précédentes dans lequel le deuxième miroir de Bragg (12) comprend des deuxièmes corrugations à base du premier matériau directement au contact d'au moins une face de la deuxième partie (120) du ruban (100), lesdites deuxièmes corrugations présentant une hauteur h2 supérieure ou égale à 5 nm.

11. Système optique selon l'une quelconque des revendications précédentes formant un laser de télédétection configuré pour être mis en oeuvre dans un système de détection et d'estimation d'une distance par laser.

12. Procédé de fabrication d'un système optique comprenant les étapes suivantes :

   - Fournir un ruban (100) à base d'un premier matériau présentant un premier indice de réfraction n1, ledit ruban (100) s'étendant principalement selon une première direction (x) et présentant une face (1100) s'étendant dans un plan d'extension principal (xy) formé par la première direction (x) et une deuxième direction (y) normale à la première direction (x),

- Déposer au moins sur une première partie de ladite face (1100) du ruban une couche de séparation (111) à base d'un deuxième matériau présentant un deuxième indice de réfraction n2 tel que n2 < n1, ladite couche de séparation (111) présentant une épaisseur e2 prise selon une troisième direction (z) normale aux première et deuxième directions (x, y),
- Déposer, sur la couche de séparation (111), une couche de perturbation à base d'un troisième matériau présentant un troisième indice de réfraction n3, tel que n2 < n3, ladite couche de perturbation présentant une épaisseur e3 prise selon la troisième direction (z),
- Graver la couche de perturbation de manière à former des corrugations (112) s'étendant principalement selon la deuxième direction (y), et présentant une hauteur h3 ≤ e3 selon la troisième direction (z), lesdites corrugations (112) formant avec la couche de séparation (111) et la première partie du ruban (100) un premier miroir de Bragg (11),
- Former un deuxième miroir de Bragg (12) au niveau d'une deuxième partie du ruban (100),
- Reporter, au niveau d'une troisième partie du ruban (100) située entre les première et deuxième parties, un milieu amplificateur à base d'un quatrième matériau.

**13.** Procédé selon la revendication précédente comprenant en outre une encapsulation des corrugations (112) par une couche d'encapsulation à base du deuxième matériau.

**14.** Procédé selon l'une quelconque des deux revendications précédentes dans lequel l'arrêt de la gravure est effectué au niveau d'une interface (1110) entre la couche de séparation (111) et la couche de perturbation, de sorte que la hauteur h3 des corrugations (112) soit égale à l'épaisseur e3 de la couche de perturbation.

**15.** Procédé selon l'une quelconque des trois revendications précédentes dans lequel la hauteur h3 des corrugations (112) est supérieure ou égale à 5 nm et/ou inférieure ou égale à 30 nm et l'épaisseur e2 de la couche de séparation (111) est supérieure ou égale à 20 nm et/ou inférieure ou égale à 50 nm.

**Patentansprüche**

**1.** Optisches System, das Folgendes umfasst:

- ein Band (100) auf Basis eines ersten Materials mit einem ersten Brechungsindex n1, wobei sich das Band (100) hauptsächlich in einer ersten Richtung (x) erstreckt und dazu bestimmt ist, eine Ausbreitung einer Lichtstrahlung der Wellenlänge λ in der ersten Richtung (x) zu leiten,
- einen ersten Bragg-Spiegel (11), der aus einem ersten Teil des Bands (100) gebildet ist, wobei der erste Bragg-Spiegel (11) ferner Wellungen (112) an mindestens einer Fläche (1100) des ersten Teils (110) des Bands (100) umfasst, wobei sich die Wellungen (112) hauptsächlich in einer zweiten Richtung (y) erstrecken, die normal zur ersten Richtung (x) ist, und eine Höhe h3 in einer dritten Richtung (z), die normal zu der ersten und der zweiten Richtung (x, y) ist, aufweisen, wobei die Wellungen (112) des ersten Bragg-Spiegels (11) durch eine Trennschicht (111) auf Basis eines zweiten Materials mit einer Dicke e2 in der dritten Richtung (z) und mit einem zweiten Brechungsindex n2 von der mindestens einen Fläche (1100) des ersten Teils (110) des Bands (100) getrennt sind, wobei die Wellungen (112) auf einem dritten Material mit einem dritten Brechungsindex n3 basieren, so dass n2 < n3 und n2 < n1,
- einen zweiten Bragg-Spiegel (12), der einen zweiten Teil des Bands (100) umfasst, und
- einen optischen Hohlraum, der sich zwischen dem ersten und dem zweiten Bragg-Spiegel (11, 12) befindet und einen dritten Teil des Bands (100) umfasst, und
- ein verstärkendes Medium auf Basis eines vierten Materials im dritten Teil des Bands (100).

**2.** Optisches System nach dem vorhergehenden Anspruch, wobei die Wellungen (112) in einer Kapselungsschicht auf Basis des zweiten Materials eingekapselt sind.

**3.** Optisches System nach einem der vorhergehenden Ansprüche, wobei die Höhe h3 der Wellungen größer oder gleich 5 nm und/oder kleiner oder gleich 30 nm ist.

**4.** Optisches System nach einem der vorhergehenden Ansprüche, wobei die Dicke e2 der Trennschicht (111) größer oder gleich 10 nm und/oder kleiner oder gleich 50 nm ist.

**5.** Optisches System nach einem der vorhergehenden Ansprüche, wobei die Wellungen ein adiabatisches Muster (30) aufweisen, das in einer Haupterstreckungsebene (xy) vorsteht, die durch die erste und die zweite Richtung (x, y) gebildet wird.

**6.** Optisches System nach einem der vorhergehenden Ansprüche, wobei die Höhe h3 und die Dicke e2 derart konfiguriert sind, dass der erste Spiegel (11) eine spektrale Bandbreite $\delta\omega_{DBR}$ kleiner oder gleich 0,5 nm aufweist.

7. Optisches System nach einem der vorhergehenden Ansprüche, wobei der erste Brechungsindex n1 größer oder gleich 3 ist, der zweite Brechungsindex n2 kleiner oder gleich 2 ist und der dritte Brechungsindex n3 größer oder gleich 1,5 ist.

8. Optisches System nach einem der vorhergehenden Ansprüche, wobei der optische Hohlraum eine Länge Lc in der ersten Richtung (x) größer oder gleich 500 μm, vorzugsweise größer oder gleich 1 mm und vorzugsweise größer oder gleich 3 mm, aufweist.

9. Optisches System nach einem der vorhergehenden Ansprüche, wobei der zweite Bragg-Spiegel (12) ein Reflexionsvermögen von größer oder gleich 99 % und eine spektrale Bandbreite $\delta\omega_{DBR2}$ von größer oder gleich 2 nm aufweist.

10. Optisches System nach einem der vorhergehenden Ansprüche, wobei der zweite Bragg-Spiegel (12) zweite Wellungen auf Basis des ersten Materials umfasst, die direkt mit mindestens einer Fläche des zweiten Teils (120) des Bands (100) in Kontakt stehen, wobei die zweiten Wellungen eine Höhe h2 größer oder gleich 5 nm aufweisen.

11. Optisches System nach einem der vorhergehenden Ansprüche, das einen Fernerkundungslaser bildet, der so konfiguriert ist, dass er von einem Erfassungs- und Schätzungs-Lasersystem für eine Entfernung implementiert wird.

12. Verfahren zum Herstellen eines optischen Systems, das die folgenden Schritte umfasst:

- Bereitstellen eines Bands (100) auf Basis eines ersten Materials mit einem ersten Brechungsindex n1, wobei sich das Band (100) hauptsächlich in einer ersten Richtung (x) erstreckt und eine Fläche (1100) aufweist, die sich in einer Haupterstreckungsebene (xy) erstreckt, die durch die erste Richtung (x) und eine zweite Richtung (y), die normal zur ersten Richtung (x) ist, gebildet wird,

- Aufbringen, zumindest auf einem ersten Teil der Fläche (1100) des Bands, einer Trennschicht (111) auf der Basis eines zweiten Materials mit einem zweiten Brechungsindex n2, so dass n2 < n1, wobei die Trennschicht (111) eine Dicke e2 in einer dritten Richtung (z), die normal zu der ersten und der zweiten Richtung (x, y) ist, aufweist,

- Aufbringen, auf der Trennschicht (111), einer Störschicht auf Basis eines dritten Materials mit einem dritten Brechungsindex n3, so dass n2 < n3, wobei die Störschicht eine Dicke e3 in der dritten Richtung (z) aufweist,

- Ätzen der Störschicht, um Wellungen (112) zu bilden, die sich hauptsächlich in der zweiten Richtung (y) erstrecken und eine Höhe h3 ≤ e3 in der dritten Richtung (z) aufweisen, wobei die Wellungen (112) mit der Trennschicht (111) und dem ersten Teil des Bands (100) einen ersten Bragg-Spiegel (11) bilden,

- Bilden eines zweiten Bragg-Spiegels (12) an einem zweiten Teil des Bands (100),

- Übertragen eines Verstärkungsmediums auf Basis eines vierten Materials auf einen dritten Teil des Bands (100), der sich zwischen dem ersten und dem zweiten Teil befindet.

13. Verfahren nach dem vorhergehenden Anspruch, das ferner das Einkapseln der Wellungen (112) durch eine Kapselungsschicht auf Basis des zweiten Materials umfasst.

14. Verfahren nach einem der vorhergehenden Ansprüche, wobei das Stoppen des Ätzens an einer Grenzfläche (1110) zwischen der Trennschicht (111) und der Störschicht derart durchgeführt wird, dass die Höhe h3 der Wellungen (112) gleich der Dicke e3 der Störschicht ist.

15. Verfahren nach einem der vorhergehenden Ansprüche, wobei die Höhe h3 der Wellungen (112) größer oder gleich 5 nm und/oder kleiner oder gleich 30 nm ist und die Dicke e2 der Trennschicht (111) größer oder gleich 20 nm und/oder kleiner oder gleich 50 nm ist.

## Claims

1. An optical system comprising:

- a ribbon (100) based on a first material having a first refractive index n1, said ribbon (100) mainly extending along a first direction (x) and being intended to guide propagation of light radiation of wavelength A along said first direction (x),
- a first Bragg mirror (11) formed from a first part of said ribbon (100), said first Bragg mirror (11) further comprising corrugations (112) at at least one face (1100) of said first part (110) of ribbon (100), said corrugations (112) mainly extending along a second direction (y) normal to the first direction (x) and having a height h3 along a third direction (z) normal to the first and second directions (x, y), the corrugations (112) of said first Bragg mirror (11) being separated from said at least one face (1100) of the first part (110) of ribbon (100) by a separation layer (111) based on a second material having a thickness e2 taken along the third direction (z) and having a second refractive index n2, the corrugations (112) being based on a third material having a third refractive index n3, such that n2 < n3 and n2 < n1,

- a second Bragg mirror (12) comprising a second part of the ribbon (100), and

- an optical cavity located between the first and second Bragg mirrors (11, 12) comprising a third part of the ribbon (100), and

- an amplifying medium based on a fourth material, at said third part of the ribbon (100).

2. The optical system according to the preceding claim, wherein the corrugations (112) are encapsulated in an encapsulation layer based on the second material.

3. The optical system according to any of the preceding claims, wherein the height h3 of the corrugations is greater than or equal to 5 nm and/or less than or equal to 30 nm.

4. The optical system according to any of the preceding claims, wherein the thickness e2 of the separation layer (111) is greater than or equal to 10 nm and/or less than or equal to 50 nm.

5. The optical system according to any of the preceding claims, wherein the corrugations have an adiabatic pattern (30) projecting into a main extension plane (xy) formed by the first and second directions (x, y).

6. The optical system according to any of the preceding claims, wherein the height h3 and the thickness e2 are configured such that the first mirror (11) has a spectral bandwidth $\delta\omega_{DBR}$ less than or equal to 0.5 nm.

7. The optical system according to any of the preceding claims, wherein the first refractive index n1 is greater than or equal to 3, the second refractive index n2 is less than or equal to 2, and the third refractive index n3 is greater than or equal to 1.5.

8. The optical system according to any of the preceding claims, wherein the optical cavity has a length Lc along the first direction (x) greater than or equal to 500 $\mu$m, preferably greater than or equal to 1 mm, and preferably greater than or equal to 3 mm.

9. The optical system according to any of the preceding claims, wherein the second Bragg mirror (12) has a reflectivity greater than or equal to 99% and a spectral bandwidth $\delta\omega_{DBR2}$ greater than or equal to 2 nm.

10. The optical system according to any of the preceding claims, wherein the second Bragg mirror (12) comprises second corrugations based on the first material directly in contact with at least one face of the second part (120) of the ribbon (100), said second corrugations having a height h2 greater than or equal to 5 nm.

11. The optical system according to any of the preceding claims forming a remote sensing laser configured to be implemented in a system for detecting and estimating a distance by laser.

12. A method for manufacturing an optical system comprising the following steps of:

- providing a ribbon (100) based on a first material having a first refractive index n1, said ribbon (100) mainly extending along a first direction (x) and having a face (1100) extending in a main extension plane (xy) formed by the first direction (x) and a second direction (y) normal to the first direction (x),

- depositing at least onto a first part of said face (1100) of the ribbon a separation layer (111) based on a second material having a second refractive index n2 such that n2 < n1, said separation layer (111) having a thickness e2 taken along a third direction (z) normal to the first and second directions (x, y),

- depositing, onto the separation layer (111), a disturbance layer based on a third material having a third refractive index n3, such that n2 < n3, said disturbance layer having a thickness e3 taken along the third direction (z),

- etching the disturbance layer so as to form corrugations (112) mainly extending along the second direction (y), and having a height $h3 \leq e3$ along the third direction (z), said corrugations (112) forming a first Bragg mirror (11) together with the separation layer (111) and the first part of the ribbon (100),

- forming a second Bragg mirror (12) at a second part of the ribbon (100),

- transferring, at a third part of the ribbon (100) located between the first and second parts, an amplifying medium based on a fourth material.

13. The method according to the preceding claim, further comprising encapsulating the corrugations (112) with an encapsulation layer based on the second material.

14. The method according to any of the two preceding claims, wherein etching stop is performed at an interface (1110) between the separation layer (111) and the disturbance layer, so that the height h3 of the corrugations (112) is equal to the thickness e3 of the disturbance layer.

15. The method according to any of the three preceding claims, wherein the height h3 of the corrugations (112) is greater than or equal to 5 nm and/or less than or equal to 30 nm, and the thickness e2 of the separation layer (111) is greater than or equal to 20 nm and/or less than or equal to 50 nm.

12    101    100   10,20    102    11

FIG. 1A

12    10    100    20    11

120         130         110

FIG. 1B

$M_{-1}$   $M_0$   $ISL_\lambda$   $M_{+1}$

Intensité

Fréquence

FIG. 2

FIG. 3A

FIG. 3B

FIG. 4A

FIG. 4B

FIG. 5A

FIG. 5B

17

EP 4 034 923 B1

FIG. 6A

FIG. 6B

18

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005089098 A2, CHANG-HASNAIN CONNIE J

**Littérature non-brevet citée dans la description**

- **D. BORDEL et al.** Heterogeneously Integrated III-V/Si Distributed Bragg Reflector Laser with Adiabatic Coupling. *39TH EUROPEAN CONFERENCE AND EXHIBITION ON OPTICAL COMMUNICATION (ECOC 2013),* 01 Janvier 2013, ISBN 978-1-84-919759-5, 687-689

- **HAN YUN et al.** Broadband 2?x?2 adiabatic 3??dB coupler using silicon-on-insulator sub-wavelength grating waveguides. *OPTICS LETTERS,* 01 Juillet 2016, vol. 41 (13), ISBN 0146-9592, 3041